# EUROPEAN PATENT SPECIFICATION

(11) **EP 1 616 211 B1**
(45) Date of publication and mention of the grant of the patent: **14.07.2010**
(21) Application number: 03727355.4
(22) Date of filing: 24.04.2003
(51) Int. Cl.: G02B 26/08, G03F 7/20

(54) **Exposure Control**
Belichtungssteuerung
Réglage d'exposition

(43) Date of publication of application: 18.01.2006
(73) Proprietor: Fraunhofer-Gesellschaft zur Förderung der angewandten Forschung e.V., 80686 München (DE); MICRONIC LASER SYSTEMS AB, 183 03 Täby (SE)
(72) Inventor: DÜRR, Peter, 01099 Dresden (DE); SANDSTRÖM, Torbjörn, 183 03 Täby (SE)
(74) Representative: Reimann, Torsten
(86) International application number: PCT/EP2003/004283
(87) International publication number: WO 2004/095110

(56) References cited:
- WO-A-03/023494
- US-B1- 6 504 644
- SEUNARINE K ET AL: "Techniques to improve the flatness of reflective micro-optical arrays" SENSORS AND ACTUATORS A, ELSEVIER SEQUOIA S.A., LAUSANNE, CH, vol. 78, no. 1, January 1999 (1999-01), pages 18-27, XP004244576 ISSN: 0924-4247

## Description

The present invention relates to a method and an apparatus for controlling exposure of a surface of a substrate. In particular, the present invention relates to an improved CD control (CD = Critical Dimension) in micro lithography pattern generators using spatial light modulators (SLM).

The prior art basically describes two different approaches for implementing a pattern generator using a SLM for generating a pattern to be transferred to a surface of a substrate.

The first approach uses large pixel deflections, i.e., the deflection is large when compared to the radiation wavelength used. Further, a substantially digital, i.e., on and off, addressing is used. An example for this first approach is the Texas Instrument's DLP chip with deflection angles of +/- 10°. With a pixel grid size of 17 µm the system can be described by classical light rays which are reflected by the individual pixels either into a projection lens (bright spot) or to an absorber (dark spot). Grey pixels can be obtained by time multiplexing for continuous light sources, and by multiple exposures for pulsed light sources.

The second approach uses a deflection at about half the radiation wavelength and an analog addressing. For this approach the SLM is described as a phase grating causing interference. Reflected light is only found in discrete diffraction orders. Conventionally, such a micro lithography pattern generator having a SLM uses the zero order to generate a pattern. That is bright spots are obtained for non-deflected pixels, and dark spots are obtained for deflected pixels. Grey pixels can be generated in one light pulse by partial deflection, as known from WO 03/023 494 A1.

In micro lithography pattern generators grey pixels are needed to obtain an addressing grid finer than the projected pixel grid. The exact grey level has to be controlled very tightly as it directly affects the uniformity of the critical dimension (CD) which is one of the most important performance parameters of micro lithography pattern generators.

The above described first prior art approach is disadvantageous in that a large amount of time for the multiple exposures is required. This reduces the throughput, a second very important performance parameter of micro lithography pattern generators. Patterning the substrates using analog addressing but still with a large deflection would cure this disadvantage. However, the precision requirements in the deflection control can not be met as the intensity in the generated image changes very quickly in a small fraction of the deflection addressing range. Even worse, the non-symmetrical illumination of the projection optics for grey pixels ruins CD control completely, even for minute focus errors.

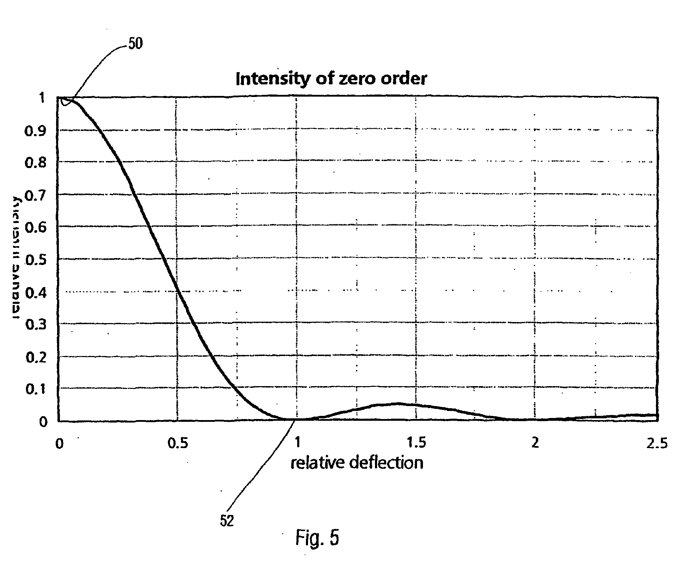

The above described second prior art approach works good for ideally flat pixels, e.g., for ideally flat micro-mirrors in a SLM. CD control is very good, and the CD is a smooth, though nonlinear function of the intensity reflected from the pixel (mirror), the reflected intensity, again, being a smooth but non-linear function of the deflection as is shown in Fig. 5. Fig. 5 is a graph of the relative intensity versus the relative deflection of a mirror of the SLM, i.e., the relative intensity of light at a predetermined pixel on a substrate to be patterned in response to a specific deflection of the mirror. As can be seen, the first maximum 50 of the intensity is obtained when the relative deflection is zero, and the first minimum 52 of the intensity is obtained when the relative deflection is one. Also a second maximum and a second minimum are shown. As can be seen from Fig. 5, binary switching of intensity between maximum and zero intensity can be simply achieved by switching deflection between zero deflection and a relative deflection of one. The maximum intensity decreases rapidly with growing deflection. Therefore, alternatively, any large relative deflection may be used for producing (near) zero intensity. As can be further seen from Fig. 5, by using the second prior art approach, a continuous change in intensity from nominal dose (maximum dose or relative intensity one) to zero (reached at a relative deflection one or nominal deflection) can be obtained.

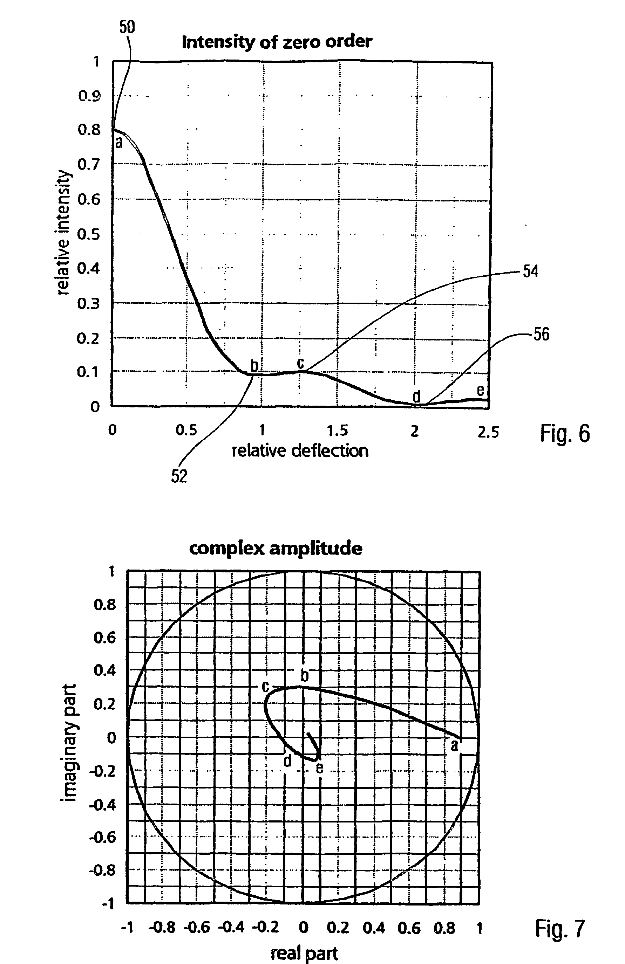

A disadvantage when producing grey levels arises from pixels (mirrors) which are not perfectly flat. Fig. 6 shows the relative intensity versus the relative deflection for pixels (mirrors) having a bend or non-planarity. For clarity, the non-planarity is quite strong, and as can be seen, the intensity in the first maximum 50 is lower than shown in Fig. 5. More importantly, the first minimum 52 does not reach zero intensity any more. This means that the contrast is reduced. Although this reduced contrast is not a problem itself as long as the minimum is reasonably low, a serious consequence of the non-planarity of the mirror is that the phase of the reflected light changes. This can be seen in detail in Fig. 7 showing the complex amplitude of the reflected light. Corresponding points in Fig. 6 and 7 have assigned the reference signs a to e. For a perfectly flat mirror the amplitude is always real. For the non-flat mirror, the phase is continuously changing with deflection. In particular, for the first minimum 52 (b) the phase is about 90° different from the phase in the maximum 50 (a), which is zero. In perfect focus, i.e., when the surface to be patterned is perfectly within focus this change of the phase would cause a minor shift in CD, which still could be accounted for. However, when leaving the focus, a first order change of the CD occurs, when compared to the second order effect for a flat pixel. Since the focus can only be finitely accurate, the CD control in a pattern generator is very limited.

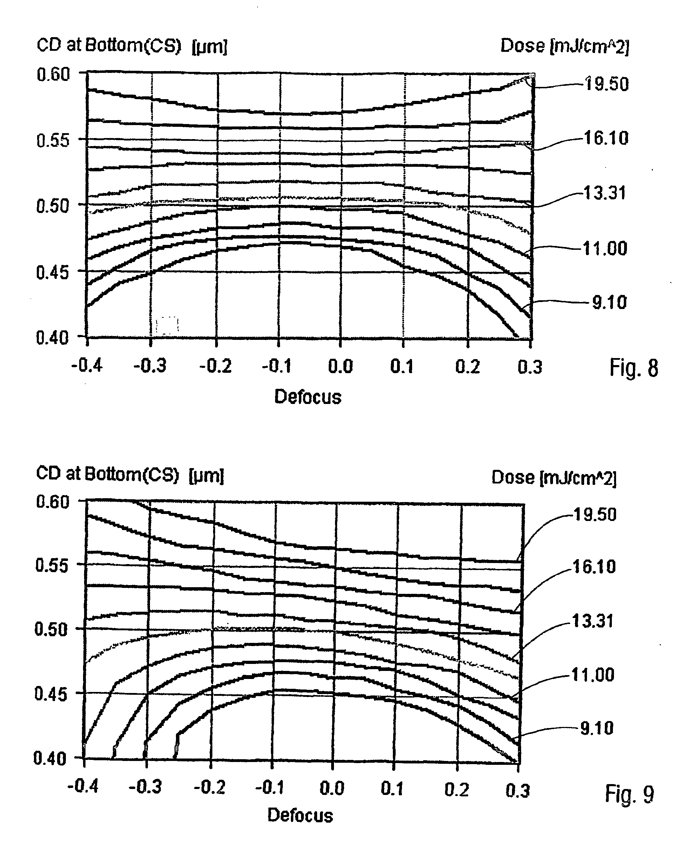

Fig. 8 and 9 are Bossung-plots of the CD versus a defocusing parameter. The defocusing parameter describes the relative deviation from the focus (defocusing parameter = 0). Fig. 8 and 9 show groups of curves for different doses, wherein the dose is the integral of the intensity over the exposure time. Fig. 8 shows the Bossung-plot for an ideally planar micro-mirror. The curves show no skew, i.e., a good control of the CD. When going through focus, the change of the CD is a second-order effect. Fig. 9 shows the Bossung-plot for a badly non-planar pixel. The graphs show a pronounced skew, which is a first-order change of the CD with defocus.

Starting from this prior art, it is the object of the present invention to provide a method and an apparatus for controlling the exposure of a substrate, such that an improved CD control despite any arrangement of the substrate out of focus is obtained and/or such that an improved contrast is obtained.

This object is achieved by a method according to claim 1, and by an apparatus according to claim 4.

The present invention provides a method according to claim 1 for controlling exposure of a surface of a substrate in a process of structuring the substrate with light of a predetermined intensity, the light being directed to the surface by means of a deflectable mirror, the intensity having a first maximum at a first deflection of the deflectable mirror, a first minimum at a second deflection of the deflectable mirror, a second maximum at a third deflection of the deflectable mirror, and a second minimum at a fourth deflection of the deflectable mirror, the method comprising:
receiving a signal representing the predetermined intensity;
receiving a signal representing a threshold intensity, the threshold intensity being equal to or less than the intensity of the second maximum;
determining whether the predetermined intensity is greater than the threshold intensity; and
controlling the deflection of the deflectable mirror to be between the first deflection and the second deflection when the predetermined intensity is greater than the threshold intensity, and to be equal to or greater than the third deflection when the predetermined intensity is equal to or less than the threshold intensity.

The present invention provides an apparatus according to claim 4 for controlling exposure of a surface of a substrate in a process of structuring the substrate with light of a predetermined intensity, the light being directed to the surface by means of a deflectable mirror, the intensity having a first maximum at a first deflection of the deflectable mirror, a first minimum at a second deflection of the deflectable mirror, a second maximum at a third deflection of the deflectable mirror, and a second minimum at a fourth deflection of the deflectable mirror, the apparatus comprising:
means for receiving a signal representing the predetermined intensity;
means for receiving a signal representing a threshold intensity, the threshold intensity being equal to or less than the intensity of the second maximum;
a comparator for determining whether the predetermined intensity is greater than the threshold intensity; and
a controller for controlling the deflection of the deflectable mirror to be between the first deflection and the second deflection when the predetermined intensity is greater than the threshold intensity, and to be equal to or greater than the third deflection when the predetermined intensity is equal to or less than the threshold intensity.

According to one aspect, the present invention provides an imaging device comprising a light source for emitting light, a spatial light modulator defining a pixel pattern to be transferred to a surface of a substrate, receiving light from the light source, and comprising the inventive apparatus, and a movable table supporting the substrate.

Contrary to the prior art approaches described above, it is the inventive concept to use the second minimum or a higher minimum of the intensity response for dark areas on the substrate. The present invention is particularly advantageous for micro-mirrors in a spatial light modulator (SLM) where the diffraction pattern of the micro-mirror is highly sensitive to the flatness, or planarity, of a micro-mirror.

It is an advantage of the present invention that, in accordance with the inventive approach, using the second minimum an intensity almost reaching zero can be obtained. Thereby the contrast of the generated pattern is largely improved.

A further advantage of the present invention is that there is no need for any principally new technology or fabrication steps. Also, existing actuator designs can be continued to be used. To reach the larger deflection range, only some technology parameter adjustments and/or small design modifications are necessary. With this low effort, a considerable improvement of the CD control and/or of the contrast in the pattern generator using an SLM is achieved.

Preferred embodiments of the present invention will be described below with reference to the accompanying drawings, in which:
- Fig. 1: is a graph of relative intensity versus relative deflection showing only those portions used for the pattern generation in accordance with the present invention;
- Fig. 2: is a graph of the complex amplitude of the inten- sity of Fig. 1 showing only those portions used for the pattern generation in accordance with the pre- sent invention;

- Fig. 3: is a schematic view of the inventive apparatus ac- cording to a preferred embodiment;
- Fig. 4: is a schematic view of a pattern generator includ- ing a SLM being operated in accordance with the present invention;
- Fig. 5: is a graph of the relative intensity versus the relative deflection for a perfectly planar mirror;
- Fig. 6: is a graph of the relative intensity versus the relative deflection for a non-planar mirror;
- Fig. 7: is a graph of the complex amplitude of the inten- sity of Fig. 6;
- Fig. 8: is a Bossung-plot for a planar mirror; and
- Fig. 9: is a Bossung-plot for a non-planar mirror.

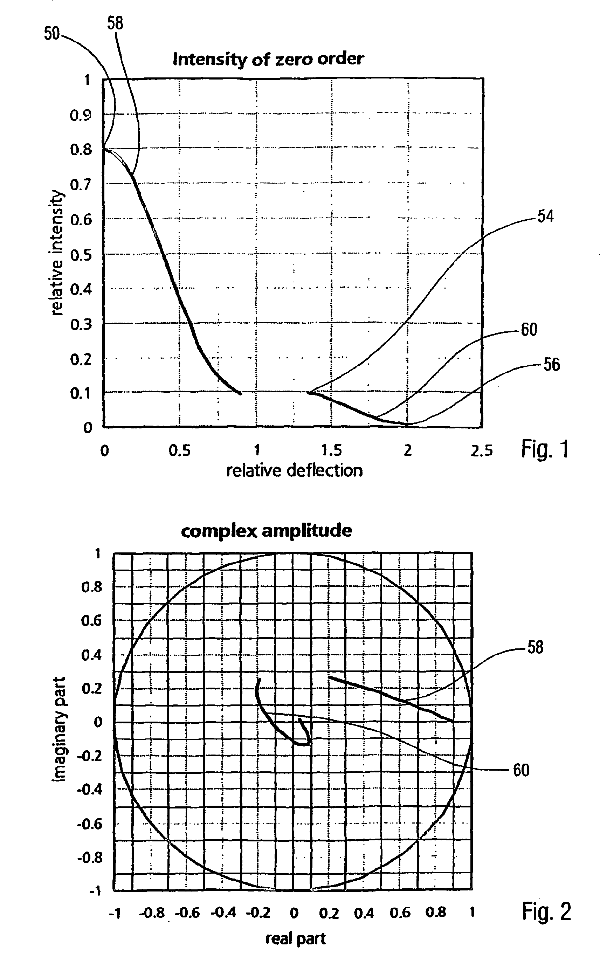

Fig. 1 is, similar to Fig. 6, a graph of relative intensity versus relative deflection, however, only those portions 58, 60 are shown which are actually used for the pattern generation in accordance with the present invention.

Fig. 2 is a graph of the complex amplitude of the intensity of Fig. 1, and likewise only shows those portions used for the pattern generation in accordance with the present invention. As can be seen from a comparison with the above-described Figs. 6 and 7, the complex amplitude in accordance with the present invention is much smaller for the second minimum (d) than for the first minimum (b). Therefore, using the second minimum instead of the first minimum causes much less problems with the defocus as was described above with reference to the Bossung-plots of Fig. 8 and 9. Although grey pixels, i.e. pixels with intermediate intensity, still have a phase different from the phase of the first maximum, the most critical region close to 90° (positive imaginary amplitude) is completely avoided. Therefore, the CD control is better and a slight defocus is less critical. By avoiding phase angles close to 90° and the non-zero absolute value of the amplitude in the second minimum, a Bossung-plot similar to that shown in Fig. 8 for an ideally planar pixel is achieved. In this way, good CD control performance is achieved by the present invention even for a substrate to be patterned slightly out of focus.

In reality, the behavior is even better than shown in Fig. 1 and 2 since the non-planarity of the mirror underlying the graphs of the Fig. 1, 2, 6 and 7 is assumed to be quite large. For a more realistic and better planarity, the complex amplitudes used according to the present invention stay even closer to the real axis. Therefore, the present invention provides for a much better CD control performance through focus.

Although the influence of the phase on the CD control is the dominant problem which is solved by the present invention, it is a positive and important side effect that the corresponding intensity is reduced, as shown in Fig. 1, almost to zero. The minimum intensity is reduced by a large factor when the second minimum is used instead of the first minimum. Thereby the contrast of the generated pattern is largely improved.

For a non-planar mirror, the minima usually decrease with increasing deflection. Therefore, in order to further reduce the minimum intensity, even higher minima could be used. However, this would require an increased deflection addressing range, without much additional benefit. In order to avoid the necessity of an increased addressing resolution, a non-linear driver circuit is preferred which provides for high deflection addressing resolution in the first portion 58 between relative deflection zero and 0.8, relatively low deflection addressing resolution in the second portion 60 and a large deflection addressing range at the same time. The preferred non-linear driver circuit allows for a good relative grey scale resolution by providing a high deflection addressing resolution for low relative deflections where the intensity changes fast with the deflection and a lower deflection addressing resolution in the upper half of the deflection range where the intensity changes only slowly with the deflection and less deflection resolution is required therefore.

The present invention provides a simple way to obtain high grey scale accuracy with non-planar mirrors. In particular, the present invention is easier to implement than any further improvement of the planarity of the mirrors. It merely requires the rather simple adaptation of the controllers controlling the micro-mirrors. This adaptation can be done starting from existing SLM chips and micro lithography pattern generators. Thereby, the present invention allows faster and overall cheaper development of SLMs and pattern generators with the desired CD uniformity.

The concept underlying the present invention does not need any principally new technology or fabrication steps. Also, existing actuator designs can be continued to be used. To reach the larger deflection range, only some technology parameter adjustments and/or small design modifications might be made. With this low effort, a considerable improvement of the CD control and/or of the contrast in the pattern generator using an SLM of the realistic limited planarity is achieved.

As already outlined above, the inventive concept is easily implemented for pattern generators for other purposes than micro lithography using an SLM as a diffractive phase grating. Regardless of what technology is used for realizing SLMs, and what application or purpose they are made for, for real devices one has to be aware of an unwanted and systematic non-planarity and a resulting phase variation that is hard and costly to reduce by technological development. In all these cases the present invention improves the image quality with quite little effort.

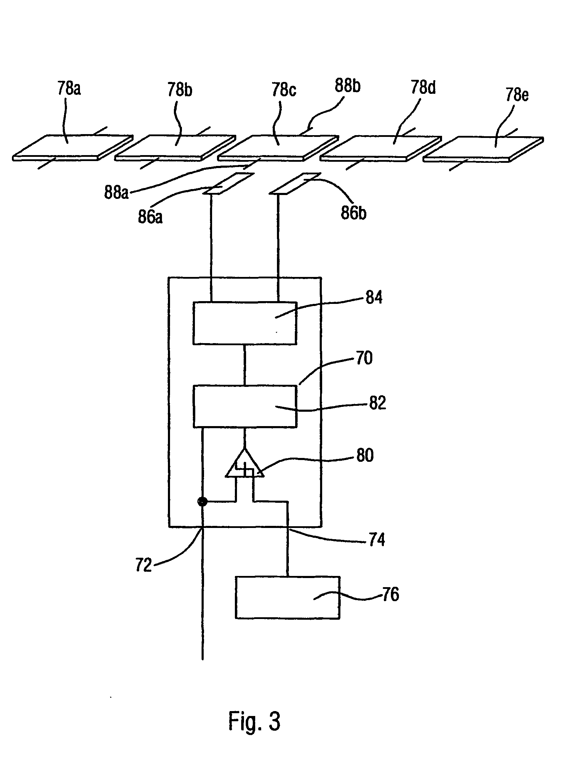

Fig. 3 shows the inventive apparatus according to a preferred embodiment. The apparatus 70 comprises an input 72 for receiving a signal representing a predetermined intensity and an input 74 for receiving a signal representing a threshold intensity, preferably a non-zero threshold intensity. The signal representing the predetermined intensity usually is provided by an external device, e.g. a computer, in the memory of which the pattern to be transferred to a substrate is stored as a bitmap. The apparatus 70 further comprises a comparator 80 for determining whether the predetermined intensity received at the input 72 is greater than the threshold intensity received at input 74. Further, the apparatus 70 comprises a controller 82 connected to the input 72 and receiving the predetermined intensity. The controller 82 is connected to the comparator 80 and receives a signal indicating whether the predetermined intensity at input 72 is greater than the threshold intensity at input 74. Controller 82 controls a driver circuit 84 which is connected to actuators 86a, 86b, for examples electrodes arranged in parallel to and below a micro-mirror 78c. The driver 84 applies voltages to the actuators 86a, 86b thereby producing electrostatic fields and electrostatic forces between the actuators 86a, 86b and the micro-mirror 78c. The micro-mirror 78c is supported by hinges 88a, 88b. The micro-mirror 78c is a non-planar micro-mirror the intensity response versus deflection (intensity response curve) and the complex amplitude of which are shown in Fig. 6 and 7. In the memory 76, the intensity of the second maximum is stored. Besides the above described implementation of the SLM with a plurality of electro-statically controlled mirrors other well known implementations of a SLM can be used in which the deflection of the pixels would be controlled accordingly.

If the apparatus 70 receives at the input 72 a signal representing a predetermined intensity which is greater than the threshold intensity, the deflection of the mirror will be controlled such that an intensity in the first portion 58 in Fig. 1 and 2 is obtained, i.e., a deflection between the deflection corresponding to the first maximum and the deflection corresponding to the first minimum. If the predetermined intensity is equal to or less than the threshold intensity, the controller 82 via the driver circuit 84 and the actuators 86a, 86b will control the deflection of the micro-mirror so as to obtain an intensity to be in the second portion 16 shown in Fig. 1 and 2, i.e., between the deflections corresponding to the second maximum and the second minimum.

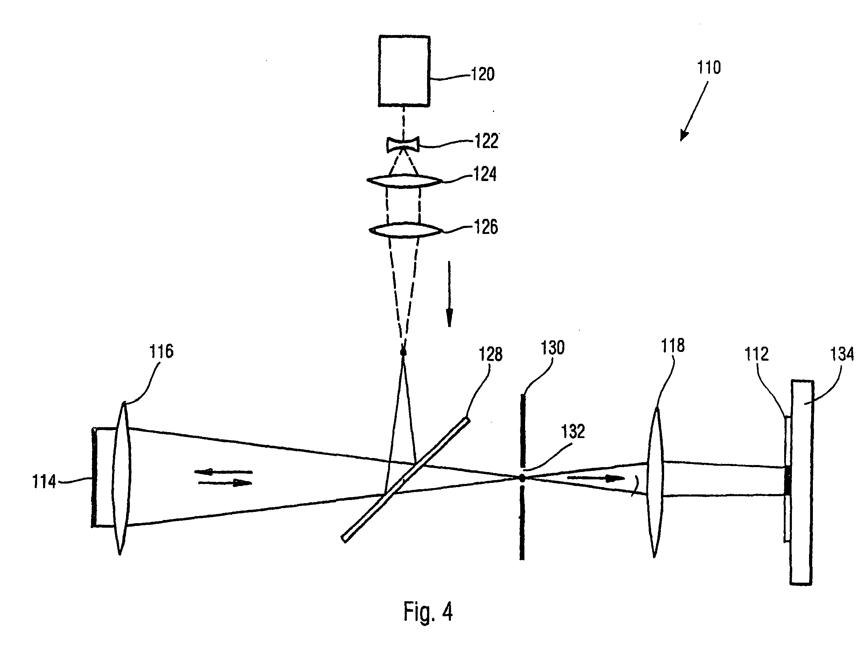

Fig. 4 shows an example for a pattern generator 110 for the exposure of a substrate 112. The pattern generator is for example similar to the one described above for the second prior art approach, i.e. the system no longer described by classical light rays, and a SLM used is described as a phase grating generating interference. The SLM is controlled in accordance with the present invention as outlined above. The substrate 112 is for example a semiconductor wafer or a quartz plate with a thin chrome layer, which is to be patterned to obtain a mask. The pattern to be produced is generated by appropriately programming the pixels (mirrors) of the SLM. The pattern is transferred via an imaging system having two lenses 116 and 118 to the substrate. A light source 120, e.g., laser, illuminates the SLM 14 via optics 126 and the partially reflective plate 128. A screen 130 is arranged with an aperture 132. In this way, light reflected from a micro-mirror of the SLM not being deflected passes through the aperture 132 and illuminates the associated pixel on the substrate 112. The screen 130 blocks light reflected from a micro-mirror of the SLM being deflected. The substrate 112 is supported by a movable table 134.

The present invention is preferably applied to systems which can not be described by classical light rays.

### List of reference numerals

- 50: first maximum
- 52: first minimum
- 54: second maximum
- 56: second minimum
- 58: first branch
- 60: second branch
- 70: controller
- 72: input
- 74: input
- 76: memory
- 78a, ...,78e: micro-mirror
- 80: comparator
- 82: logic device
- 84: driver circuit
- 86a, 86b: actuator
- 88a, 88b: hinge
- 110: stepper
- 112: substrate
- 114: reticle
- 116: first lens
- 118: second lens
- 120: laser
- 122: beam expansion lens
- 124: collimator
- 126: focusing lens
- 128: partially reflective plate
- 130: screen
- 132: aperture
- 134: stage

## Claims

1. A method for providing an improved CD control performance through focus despite any arrangement of a substrate (112) out of focus and/or an improved contrast, the method controlling exposure of a surface of the substrate (112) in a process of structuring the substrate (112) with light of a predetermined intensity, the light being directed to the surface by means of a non-planar deflectable mirror (78c), the intensity having a first maximum (50) at a first deflection of the non-planar deflectable mirror (78c), a first minimum (52) at a second deflection of the non-planar deflectable mirror (78c), a second maximum (54) at a third deflection of the non-planar deflectable mirror (78c), and a second minimum (56) at a fourth deflection of the non-planar deflectable mirror (78c), the method comprising:
receiving a signal representing the predetermined intensity; **characterised by** the further steps of:
receiving a signal representing a threshold intensity, the threshold intensity being a non-zero intensity equal to or less than the intensity of the second maximum (54);
determining whether the predetermined intensity is greater than the threshold intensity; and
controlling the deflection of the non-planar deflectable mirror (78c) to be between the first deflection and the second deflection when the predetermined intensity is greater than the threshold intensity, and to be equal to or greater than the third deflection when the predetermined intensity is equal to or less than the threshold intensity, wherein the first maximum is the brightest maximum (50) of the intensity response curve of the non-planar deflectable mirror (78c), the first minimum is the minimum (52) next to the first maximum of the intensity response curve, the second maximum is a weaker maximum (54) of the intensity response curve either next to the first minimum or at even larger deflection, and the second minimum is the minimum (56) next to the second maximum of the intensity response curve.

2. The method according to claim 1, wherein the deflection of the non-planar deflectable mirror (78c) is controlled to be between the third deflection and the fourth deflection when the predetermined intensity is equal to or less than the threshold intensity.

3. The method according to claim 1 or 2, wherein the step of controlling comprises actuating the non-planar deflectable mirror by means of a non-linear driver circuit (84).

4. An apparatus providing an improved CD control performance through focus and/or an improved contrast, the apparatus controlling exposure of a surface of a substrate (112) in a process of structuring the substrate (112) with light of a predetermined intensity, the light being directed to the surface by means of a non-planar deflectable mirror (78c), the intensity having a first maximum (50) at a first deflection of the non-planar deflectable mirror (78c), a first minimum (52) at a second deflection of the non-planar deflectable mirror (78c), a second maximum (54) at a third deflection of the non-planar deflectable mirror (78c), and a second minimum (56) at a fourth deflection of the non-planar deflectable mirror (78c), the apparatus comprising:
means (72) for receiving a signal representing the predetermined intensity; said apparatus being **characterised by**
means (74) for receiving a signal representing a threshold intensity, the threshold intensity being a non-zero intensity equal to or less than the intensity of the second maximum (54);
a comparator (80) for determining whether the predetermined intensity is greater than the threshold intensity;
a controller arranged to control the deflection of the non-planar deflectable mirror (78c) to be between the first deflection and the second deflection when the predetermined intensity is greater than the threshold intensity, and to be equal to or greater than the third deflection when the predetermined intensity is equal to or less than the threshold intensity, wherein the first maximum is the brightest maximum (50) of the intensity response curve of the non-planar deflectable mirror (78c), the first minimum is the minimum (52) next to the first maximum of the intensity response curve, the second maximum is a weaker maximum (54) of the intensity response curve either next to the first minimum or at even larger deflection, and the second minimum is the minimum (56) next to the second maximum of the intensity response curve.

5. The apparatus according to claim 4, wherein the controller is further implemented such that the deflection of the non-planar deflectable mirror (78c) is between the third deflection and the fourth deflection when the predetermined intensity is equal to or less than the threshold intensity.

6. The apparatus according to claim 4 or 5, wherein the non-planar deflectable mirror is a reflective mirror (78c) of a spatial light modulator generating an interference pattern.

7. The apparatus according to one of claims 4 to 6, further comprising an actuator (86a, 86b) associated with the non-planar deflectable mirror, and a non-linear driver circuit (84) for driving the actuator (86a, 86b).

8. An imaging device (110), comprising:
a light source (120) for emitting light;
a spatial light modulator defining a pixel pattern to be transferred to a surface of a substrate, and receiving light from the light source, the spatial light modulator comprising an apparatus according to one of claims 4 to 7; and
a movable table (134) supporting the substrate (112).

## Patentansprüche

1. Verfahren zur Erzielung einer verbesserten CD-Einstellpräzision bei Defokussierung, ungeachtet einer defokussierten Anordnung eines Substrats (112), und/oder eines verbesserten Kontrasts, wobei das Verfahren das Belichten einer Oberfläche des Substrats (112) in einem Vorgang des Strukturierens des Substrats (112) mit Licht einer vorbestimmten Intensität steuert, wobei das Licht mittels eines nicht planaren ablenkbaren Spiegels (78c) zu der Oberfläche gerichtet wird, wobei die Intensität ein erstes Maximum (50) bei einer ersten Ablenkung des nicht planaren ablenkbaren Spiegels (78c), ein erstes Minimum (52) bei einer zweiten Ablenkung des nicht planaren ablenkbaren Spiegels (78c), ein zweites Maximum (54) bei einer dritten Ablenkung des nicht planaren ablenkbaren Spiegels (78c) und ein zweites Minimum (56) bei einer vierten Ablenkung des nicht planaren ablenkbaren Spiegels (78c) hat, wobei das Verfahren Folgendes umfasst:
Empfangen eines Signals, das die vorbestimmte Intensität darstellt, **gekennzeichnet durch** die folgenden weiteren Schritte:
Empfangen eines Signals, das eine Schwellenintensität darstellt, wobei die Schwellenintensität eine Intensität ungleich Null ist, die gleich der Intensität des zweiten Maximums (54) oder geringer ist,
Bestimmen, ob die vorbestimmte Intensität größer ist als die Schwellenintensität, und
Steuern der Ablenkung des nicht planaren ablenkbaren Spiegels (78c) so, dass sie zwischen der ersten Ablenkung und der zweiten Ablenkung liegt, wenn die vorbestimmte Intensität größer ist als die Schwellenintensität, und dass sie gleich der dritten Ablenkung oder größer ist, wenn die vorbestimmte Intensität gleich der Schwellenintensität oder geringer ist, wobei das erste Maximum das hellste Maximum (50) der Intensitätsgangkurve des nicht planaren ablenkbaren Spiegels (78c) ist, das erste Minimum das Minimum (52) neben dem ersten Maximum der Intensitätsgangkurve ist, das zweite Maximum ein schwächeres Maximum (54) der Intensitätsgangkurve entweder neben dem ersten Minimum oder bei einer noch größeren Ablenkung ist und das zweite Minimum das Minimum (56) neben dem zweiten Maximum der Intensitätsgangkurve ist.

2. Verfahren nach Anspruch 1, wobei die Ablenkung des nicht planaren ablenkbaren Spiegels (78c) so gesteuert wird, dass sie zwischen der dritten Ablenkung und der vierten Ablenkung liegt, wenn die vorbestimmte Intensität gleich der Schwellenintensität oder geringer ist.

3. Verfahren nach Anspruch 1 oder 2, wobei der Schritt des Steuerns umfasst, den nicht planaren ablenkbaren Spiegel mittels einer nicht linearen Treiberschaltung (84) zu betätigen.

4. Vorrichtung, die eine verbesserte CD-Einstellpräzision bei Defokussierung und/oder einen verbesserten Kontrast gewährleistet, wobei die Vorrichtung das Belichten einer Oberfläche eines Substrats (112) in einem Vorgang des Strukturierens des Substrats (112) mit Licht einer vorbestimmten Intensität steuert, wobei das Licht mittels eines nicht planaren ablenkbaren Spiegels (78c) zu der Oberfläche gerichtet wird, wobei die Intensität ein erstes Maximum (50) bei einer ersten Ablenkung des nicht planaren ablenkbaren Spiegels (78c), ein erstes Minimum (52) bei einer zweiten Ablenkung des nicht planaren ablenkbaren Spiegels (78c), ein zweites Maximum (54) bei einer dritten Ablenkung des nicht planaren ablenkbaren Spiegels (78c) und ein zweites Minimum (56) bei einer vierten Ablenkung des nicht planaren ablenkbaren Spiegels (78c) hat, wobei die Vorrichtung Folgendes umfasst:
Mittel (72) zum Empfangen eines Signals, das die vorbestimmte Intensität darstellt, wobei die Vorrichtung durch Folgendes **gekennzeichnet** ist:
Mittel (74) zum Empfangen eines Signals, das eine Schwellenintensität darstellt, wobei die Schwellenintensität eine Intensität ungleich Null ist, die gleich der Intensität des zweiten Maximums (54) oder geringer ist,
einen Vergleicher (80) zum Bestimmen, ob die vorbestimmte Intensität größer ist als die Schwellenintensität, und
eine Steuerung, angeordnet zum Steuern der Ablenkung des nicht planaren ablenkbaren Spiegels (78c) so, dass sie zwischen der ersten Ablenkung und der zweiten Ablenkung liegt, wenn die vorbestimmte Intensität größer ist als die Schwellenintensität, und dass sie gleich der dritten Ablenkung oder größer ist, wenn die vorbestimmte Intensität gleich der Schwellenintensität oder geringer ist, wobei das erste Maximum das hellste Maximum (50) der Intensitätsgangkurve des nicht planaren ablenkbaren Spiegels (78c) ist, das erste Minimum das Minimum (52) neben dem ersten Maximum der Intensitätsgangkurve ist, das zweite Maximum ein schwächeres Maximum (54) der Intensitätsgangkurve entweder neben dem ersten Minimum oder bei einer noch größeren Ablenkung ist und das zweite Minimum das Minimum (56) neben dem zweiten Maximum der Intensitätsgangkurve ist.

5. Vorrichtung nach Anspruch 4, wobei die Steuerung ferner derart ausgeführt ist, dass die Ablenkung des nicht planaren ablenkbaren Spiegels (78c) zwischen der dritten Ablenkung und der vierten Ablenkung liegt, wenn die vorbestimmte Intensität gleich der Schwellenintensität oder geringer ist.

6. Vorrichtung nach Anspruch 4 oder 5, wobei der nicht planare ablenkbare Spiegel ein reflektierender Spiegel (78c) eines räumlichen Lichtmodulators ist, der ein Interferenzmuster erzeugt.

7. Vorrichtung nach einem der Ansprüche 4 bis 6, die ferner ein Stellglied (86a, 86b), das dem nicht planaren ablenkbaren Spiegel zugeordnet ist, und eine nicht lineare Treiberschaltung (84) zum Ansteuern des Stellglieds (86a, 86b) umfasst.

8. Abbildende Einrichtung (110), die Folgendes umfasst:
eine Lichtquelle (120) zum Emittieren von Licht,
einen räumlichen Lichtmodulator, der ein auf eine Oberfläche eines Substrats zu übertragendes Bildpunktmuster definiert und Licht von der Lichtquelle empfängt, wobei der räumliche Lichtmodulator eine Vorrichtung nach einem der Ansprüche 4 bis 7 umfasst, und
einen beweglichen Tisch (134), der das Substrat (112) trägt.

## Revendications

1. Procédé destiné à l'obtention d'une amélioration de la précision de commande de la dimension critique (CD) lors d'une défocalisation, en dépit d'une disposition défocalisée du substrat (112), et/ou une amélioration du contraste, ce procédé régulant l'exposition d'une surface du substrat (112) dans un processus de structuration du substrat (112) à l'aide d'une lumière d'intensité prédéterminée, cette lumière étant dirigée vers la surface au moyen d'un miroir de déviation non-planaire (78c), l'intensité ayant une première valeur maximale (50) lors d'une première déviation du miroir non planaire (78c), une première valeur minimale (52) lors d'une seconde déviation du miroir de déviation non-planaire (78c), une seconde valeur maximale (54) lors d'une troisième déviation du miroir de déviation non planaire (78c) et une seconde valeur minimale (56) lors d'une quatrième déviation du miroir de déviation non planaire, ce procédé incluant les étapes suivantes :
la réception d'un signal représentant l'intensité prédéterminée, **caractérisée par** les autres étapes suivantes :
la réception d'un signal représentant une intensité seuil, cette intensité seuil étant égale à une intensité différente de zéro, égale ou inférieure à l'intensité de la seconde valeur maximale (54) ;
l'évaluation de l'intensité prédéterminée - si celle-ci est supérieure à l'intensité seuil ; et
la commande de la déviation du miroir de déviation non planaire (78c), de façon à ce qu'elle se situe entre la première déviation et la seconde déviation lorsque l'intensité prédéterminée est égale ou inférieure à l'intensité seuil, la première valeur maximale étant la valeur maximale la plus élevée (50) de la courbe d'intensité du miroir de déviation non planaire (78c), la première valeur minimale étant la valeur minimale (52) près de la première valeur maximale de la courbe d'intensité, la seconde valeur maximale étant une valeur maximale plus faible (54) de la courbe de réponse d'intensité, soit près de la première valeur minimale soit lors d'une déviation encore plus importante, et la seconde valeur minimale étant la valeur minimale (56) près de la seconde valeur maximale de la courbe d'intensité.

2. Procédé selon la revendication 1, au sein duquel la déviation du miroir de déviation non planaire (78c) est commandée de façon à ce qu'elle se situe entre la troisième déviation et la quatrième déviation lorsque l'intensité prédéterminée est égale ou inférieure à l'intensité seuil.

3. Procédé selon la revendication 1 ou 2, au sein duquel la phase de guidage inclut l'actionnement du miroir de déviation non planaire au moyen d'un circuit d'attaque non linéaire (84).

4. Dispositif garantissant une amélioration de la précision de réglage de la commande de la dimension critique (CD) lors d'une défocalisation et/ou une amélioration du contraste, ce dispositif commandant l'exposition d'une surface de substrat (112) dans un processus de structuration du substrat(112) à l'aide d'une lumière d'intensité prédéterminée, la lumière étant dirigée vers la surface au moyen d'un miroir de déviation non planaire (78c), l'intensité ayant une première valeur maximale (50) lors d'une première déviation du miroir de déviation non planaire (78c), une première valeur minimale (52) lors d'une seconde déviation du miroir de déviation non planaire (78c), une seconde valeur maximale (54) lors d'une troisième déviation du miroir de déviation non planaire (78 c), une seconde valeur maximale (54) lors d'une troisième déviation du miroir de déviation non planaire (78c) et une seconde valeur minimale (56) lors d'une quatrième déviation du miroir de déviation non planaire (78c), le dispositif comprenant les éléments suivants :
moyens (72) pour la réception d'un signal représentant l'intensité prédéterminée ; ledit dispositif étant **caractérisé par** :
des moyens (74) pour la réception d'un signal représentant une intensité seuil, l'intensité seuil étant une intensité différente de zéro, égale ou inférieure à l'intensité de la seconde valeur maximale (54) ;
un comparateur (80) pour évaluer si l'intensité prédéterminée est supérieure à l'intensité seuil ;
un contrôleur agencé pour guider la déviation du miroir de déviation non planaire (78c) de façon à ce qu'elle se situe entre la première déviation et la seconde déviation lorsque l'intensité prédéterminée est supérieure à l'intensité seuil, et à ce qu'elle soit égale ou supérieure à la troisième déviation lorsque l'intensité prédéterminée est égale ou inférieure à l'intensité seuil, la première valeur maximale étant la valeur maximale la plus élevée (50) de la courbe d'intensité du miroir de déviation non planaire (78c), la première valeur minimale étant la valeur minimale (52) près de la première valeur maximale de la courbe d'intensité, la seconde valeur maximale étant une valeur maximale plus faible (54) de la courbe d'intensité, soit près de la première valeur minimale soit lors d'une déviation encore plus importante, et la seconde valeur minimale étant la valeur minimale (56) près de la seconde valeur maximale de la courbe d'intensité.

5. Dispositif selon la revendication 4, au sein duquel le contrôleur est en outre configuré de telle sorte, que la déviation du miroir de déviation non planaire (78c) se situe entre la troisième déviation et la quatrième déviation lorsque l'intensité prédéterminée est égale ou inférieure à l'intensité seuil.

6. Dispositif selon la revendication 4 ou 5, au sein duquel le miroir de déviation non planaire est un miroir réflecteur (78 c) d'un modulateur spatial de lumière générant des franges d'interférence.

7. Dispositif selon l'une des revendications 4 à 6, comprenant en outre un actionneur (86a, 86b) associé au miroir de déviation non planaire et un circuit d'attaque non linéaire (84) pour commander l'actionneur (86a, 86b).

8. Dispositif d'imagerie (110) comprenant :
une source lumineuse (120) pour l'émission de lumière ;
un modulateur spatial de lumière définissant un motif de pixel à transférer sur une surface du substrat et recevant la lumière provenant de la source lumineuse, le modulateur spatial de lumière comprenant un dispositif selon l'une des revendications 4 à 7, et
une table mobile (134) supportant le substrat (112).
